(19) Europäisches Patentamt / European Patent Office / Office européen des brevets

(11) **EP 4 428 614 B1**

(12) **FASCICULE DE BREVET EUROPEEN**

(45) Date de publication et mention
de la délivrance du brevet:
**29.04.2026 Bulletin 2026/18**

(21) Numéro de dépôt: **24161171.4**

(22) Date de dépôt: **04.03.2024**

(51) Classification Internationale des Brevets (IPC):
***G03F 1/70*** *(2012.01)*

(52) Classification Coopérative des Brevets (CPC):
**G03F 7/70283; G03F 1/70; G03F 7/0005;
H10F 39/011**

(54) **PROCÉDÉ DE DIMENSIONNEMENT D'UN MASQUE DE LITHOGRAPHIE À ÉCHELLE DE GRIS**

VERFAHREN ZUR DIMENSIONIERUNG EINER GRAUSKALA-LITHOGRAPHIEMASKE

METHOD FOR SIZING A GRAY SCALE LITHOGRAPHY MASK

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **09.03.2023 FR 2302191**

(43) Date de publication de la demande:
**11.09.2024 Bulletin 2024/37**

(73) Titulaire: **COMMISSARIAT À L'ÉNERGIE
ATOMIQUE ET AUX
ÉNERGIES ALTERNATIVES
75015 Paris (FR)**

(72) Inventeur: **PALANCHOKE, Ujwol
38054 GRENOBLE CEDEX 09 (FR)**

(74) Mandataire: **Hautier IP
20, rue de la Liberté
06000 Nice (FR)**

(56) Documents cités:
**FR-A1- 2 968 780      US-A1- 2005 118 515
US-A1- 2005 233 228      US-A1- 2021 255 543**

**Description**

**DOMAINE TECHNIQUE**

La présente invention concerne le domaine de la photolithographie, plus précisément celui de la lithographie à échelle de gris ou en nuance de gris, couramment désigné par l'expression anglais « grayscale lithography ». L'invention concerne tout particulièrement l'optimisation du masque utilisé dans cette technique.

**ETAT DE LA TECHNIQUE**

La lithographie à échelle de gris est une technique de photolithographie permettant la réalisation de microstructures à trois dimensions (3D) en une unique étape de lithographique et de développement. Elle est particulièrement utilisée dans la fabrication de microéléments optiques, de MEMS (de l'anglais « microelectromechanical systems », en français microsystèmes électromécaniques), de MOEMS (de l'anglais « microoptoelectromechanical systems », en français microsystèmes optoélectromécaniques), de dispositifs microfluidiques ou encore de surfaces texturées.

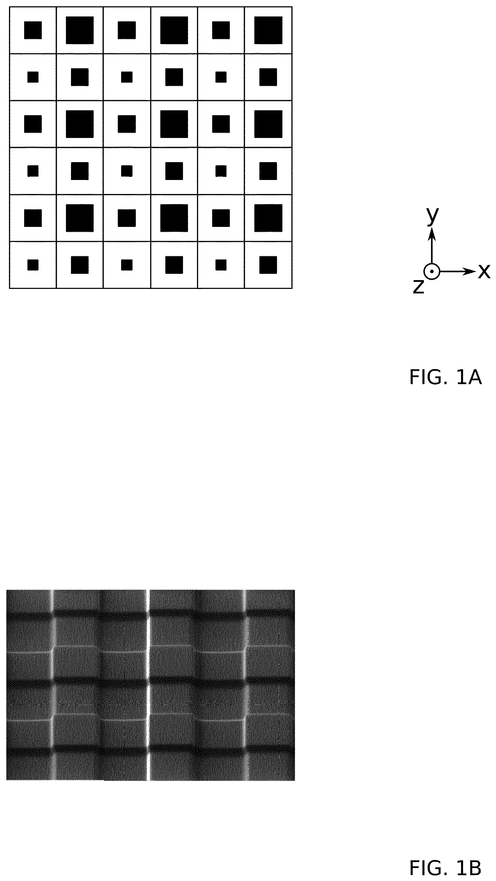

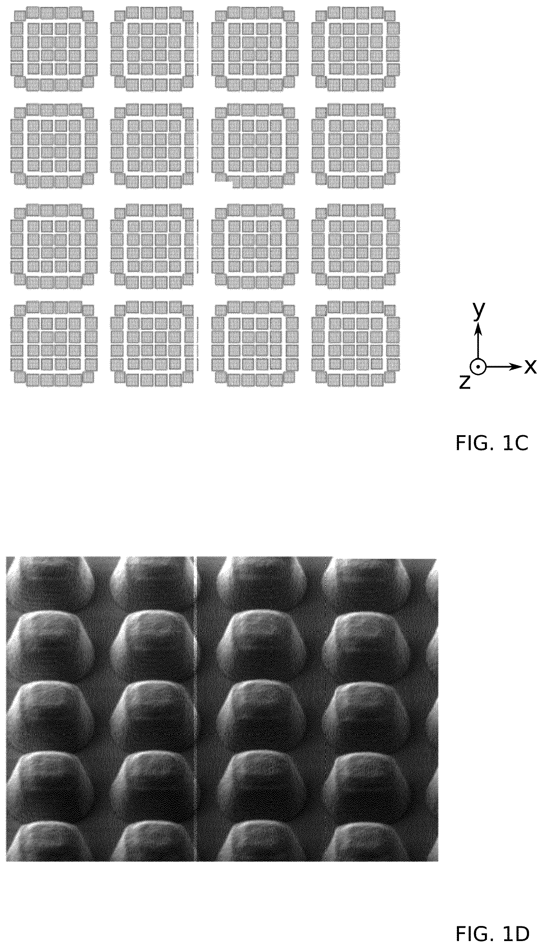

Cette technique repose sur le fait de faire varier l'épaisseur selon une dimension Z sur laquelle une résine photosensible est insolée en modulant dans l'espace la dose d'ultra-violet (UV) reçue par la résine. Une fois les portions insolées développées, la résine présente une structuration 3D (vues au microscope électronique à balayage (MEB) représentées aux figures 1B et 1D) et peut par exemple servir de moule pour la fabrication de microstructures 3D.

La dose d'ultra-violet reçue localement par la résine peut notamment être modulée en jouant sur les dimensions et le positionnement de zones opaques présentes sur le masque de lithographie (figures 1A et 1C). Ces zones opaques sont typiquement réalisées par dépôt de chrome sur un masque de verre.

La lithographie à échelle de gris permet ainsi d'obtenir des microstructures 3D présentant une hauteur caractéristique allant d'une dizaine à quelques centaines de micromètres. Cependant, la hauteur en chaque point de la microstructure est très dépendante d'erreurs de fabrication au niveau du masque.

Les documents US 2005/233228 A1, FR 2 968 780 A1, US 2021/255543 A1, US 2005/118515 A1 présentent des méthodes de fabrication de masques de lithographie à échelle de gris mais ne permettent pas d'obtenir, au niveau des microstructures fabriquées à l'aide de ces masques, une résolution en Z optimale.

Un existe donc un besoin de minimisation de l'erreur sur l'épaisseur insolée de la résine photosensible afin d'améliorer la résolution en Z des microstructures 3D fabriquées par lithographie à échelle de gris.

**RESUME**

Pour atteindre cet objectif, selon un premier aspect de l'invention concerne un procédé de dimensionnement d'un masque de lithographie en échelle de gris, le masque s'étendant principalement selon un plan horizontal défini par une première direction et une deuxième direction, le plan étant perpendiculaire à une direction principale d'un rayonnement d'insolation d'une résine photosensible au travers du masque. Le masque comprend une pluralité de zones opaques au rayonnement, chaque zone opaque se situant dans une zone du masque dite pixel, la pluralité de zones opaques comprenant des premières zones opaques se trouvant dans des premiers pixels, les premiers pixels formant un premier réseau du masque. Le procédé comprend les étapes suivantes :

a. Etablir une première densité cible $D_{100}{}^*$ d'une première densité surfacique $D_{100}$ de premières zones opaques au sein du premier réseau, la première densité cible $D_{100}{}^*$ étant configurée pour permettre d'insoler la résine sur une première épaisseur cible $e_1{}^*$ donnée lorsque la résine est exposée au rayonnement au travers du premier réseau du masque, la première épaisseur cible $e_1{}^*$ étant mesurée selon la direction principale du rayonnement,

b. Obtenir une première valeur, pour la première densité cible $D_{100}{}^*$, de la dérivée par rapport à la première densité surfacique $D_{100}$ de la première épaisseur $e_1$ sur laquelle la résine photosensible est insolée lorsqu'elle est exposée à un rayonnement au travers du premier réseau présentant la première densité surfacique $D_{100}$, ladite première valeur étant notée $\dfrac{\partial e_1(D_{100}{}^*)}{\partial D_{100}}$,

c. Déterminer une première dimension $P_{x,1}$ des premiers pixels dans la première direction, une première dimension $P_{y,1}$ des premiers pixels dans la deuxième direction, une première dimension $L_{x,1}$ des premières zones opaques dans la première direction, une première dimension $L_{y,1}$ des premières zones opaques dans la deuxième direction, de façon à ce que la valeur d'une erreur sur la première épaisseur cible $e_1{}^*$, notée $MEEF(e_1{}^*)$, soit inférieure à un premier seuil donné, $MEEF(e_1{}^*)$ étant calculée à partir de la formule suivante :

$$MEEF(e_1{}^*) = \frac{\partial e_1(D_{100}{}^*)}{\partial D_{100}} \frac{(a_1 + \beta_1)L_{x,1}}{P_{x,1}P_{y,1}}$$

Avec $\beta_1 = \frac{L_{y,1}}{L_{x,1}}$ et $a_1 = \frac{\delta L_{y,1}}{\delta L_{x,1}}$, $\delta L_{x,1}$ étant une erreur sur $L_{x,1}$ et $\delta L_{y,1}$ étant une erreur sur $L_{y,1}$,

d. Utiliser les dimensions obtenues pour le dimensionnement du premier réseau du masque.

Ces différentes étapes permettent d'optimiser le dimensionnement des pixels et des zones opaques dans le plan horizontal afin de limiter l'erreur sur l'épaisseur cible. En effet les méthodes actuelles de dimensionnement contraignent uniquement le choix de la densité de zones opaques. Une fois cette densité D fixée, sans autre contrainte, une infinité de dimensionnements des pixels et des zones opaques est possibles. Par exemple, dans le cas particulier de pixels carrés de côté P et de zones opaques carrées de côté L, tout couple (L,P) satisfaisant $L^2/P^2 = D$ pourrait convenir. Cependant, tous ces couples ne mènent pas à une résolution satisfaisante dans la direction principale de rayonnement, au niveau de la structure 3D formée.

Le procédé selon l'invention permet donc de déterminer des dimensions de pixels et de zones opaques conduisant à un niveau d'erreur satisfaisant.

Le procédé permet ainsi d'obtenir une amélioration significative de la qualité des structures 3D réalisées par lithographie à échelle de gris.

Un deuxième aspect de l'invention concerne un procédé de fabrication d'un masque de lithographie en échelle de gris comprenant les étapes suivantes :

a. Dimensionner le masque par mise en œuvre du procédé selon le premier aspect,
b. Fabriquer le masque ainsi dimensionné.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

Les figures 1A à 1D représentent des masques de lithographie à échelle de gris et des vues au microscope électronique à balayage de résines insolées à travers ces masques puis développées. Les figures 1A et 1B concernent la fabrication de structures 3D présentant des plateaux à différentes hauteurs.
Les figures 1C et 1D concernent la fabrication de microlentilles 3D présentant une forme de coupole.
La figure 2A représente un masque de lithographie à échelle de gris.
La figure 2B est une vue en coupe d'un masque de lithographie à échelle de gris en train d'être utilisé pour l'insolation d'une résine photosensible
La figure 3 illustre le profil d'une couche de résine exposée en différentes régions à des rayonnements lumineux passés au travers de masques ou régions d'un même masque présentant différentes densités de zones opaques.
La figure 4 est un graphique illustrant l'évolution de la hauteur de résine restante après exposition à un rayonnement au travers du masque de lithographie puis développement, en fonction de la densité de zones opaques au niveau dudit masque de lithographie.
La figure 5 est un graphique illustrant l'évolution de l'erreur sur la hauteur de la résine restante après exposition en fonction de la densité de zones opaques et de la pente de la courbe de contraste pour des dimensions de pixels fixées.
La figure 6 est un graphique illustrant l'évolution de l'erreur sur la hauteur de la résine restante après exposition en fonction des dimensions de pixels, à densité de zones opaques fixée.
Les figures 7A et 7B illustrent le redimensionnement d'un masque selon le procédé selon l'invention.
Les figures 8A à 8F illustrent une séquence d'étapes permettant d'établir une courbe de contraste entre la hauteur de la résine après développement et la densité de zones opaques, sans masque test.
La figure 9A est un logigramme présentant une séquence d'étapes permettant la mise en oeuvre du procédé selon l'invention pour un réseau de pixels.
La figure 9B est un logigramme présentant une séquence d'étapes permettant la mise en œuvre du procédé selon l'invention pour une pluralité de réseaux de pixels.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

Selon un mode de réalisation avantageux, a est compris entre 0,8 et 1,2, de préférence a est égal à 1.
Selon un exemple, l'étape d'obtention de la première valeur de la dérivée comprend les étapes suivantes :

    a. Fournir une résine secondaire de même nature que la résine photosensible,
    b. Insoler une pluralité de régions de la résine secondaire avec un rayonnement, chaque région étant insolée avec une dose de rayonnement distincte,
    c. Pour chaque région de la résine secondaire, déterminer selon la direction principale du rayonnement une épaisseur d'insolation du rayonnement dans ladite région,
    d. Etablir, pour chaque région de la résine secondaire, une densité théorique de zones opaques théoriques sur un masque théorique, qui, lors de l'exposition à un rayonnement de ladite région au travers du masque théorique, aurait permis d'exposer ladite région à la dose de rayonnement à laquelle ladite région est exposée,
    e. Etablir un modèle reliant l'épaisseur d'insolation de la couche de résine secondaire à la densité de zones opaques à partir des données d'épaisseur d'insolation et de densité théorique obtenues pour chacune des régions.

Selon un exemple, l'étape d'établissement, pour chaque région de la résine secondaire, de la densité théorique de zones opaques théoriques, se fait au moins par application de la formule suivante :

$$D_i = 1 - \frac{Q_i}{Q_{max}}$$

avec i indexant les différentes régions de la résine secondaire, $D_i$ la densité théorique associée à la région i, $Q_i$ la dose de rayonnement à laquelle la région i est exposée et $Q_{max}=\max(Q_i)$.
Selon un exemple, l'étape d'obtention de la première valeur de la dérivée comprend les étapes suivantes :

    a. Fournir un masque test présentant une pluralité de réseaux test présentant chacun une densité distincte de zones opaques test,
    b. Fournir une résine test de même nature que la résine photosensible,
    c. Insoler une pluralité de régions de la résine test avec un rayonnement au travers du masque test, l'insolation de chaque région se faisant au travers d'un réseau test distinct,
    d. Déterminer, pour chaque région de la résine test, une épaisseur d'insolation du rayonnement dans ladite région,
    e. Etablir un modèle reliant l'épaisseur d'insolation de la couche de résine test à la densité de zones opaques test à partir des données d'épaisseur d'insolation obtenues pour chacune des régions.

Avantageusement, la première dimension $P_{x,1}$ des premiers pixels selon la première direction et la première dimension $P_{y,1}$ des premiers pixels selon la deuxième direction sont chacune inférieures à une longueur d'onde principale du rayonnement.

De préférence, les premiers pixels présentent une forme carrée dans le plan horizontal et dans lequel $P_{x,1}=P_{y,1}=P$.

De préférence, les premières zones opaques présentent une forme carrée dans le plan horizontal et dans lequel $L_{x,1}=L_{y,1}=L$.

Selon un exemple, $MEEF(e_1{}^*) = \frac{\partial e_1(D_{100}{}^*)}{\partial D_{100}} \frac{2\sqrt{D_{100}{}^*}}{P}$.

Selon un mode de réalisation préféré, la pluralité de zones opaques comprend au moins des deuxièmes zones opaques se trouvant dans des deuxièmes pixels, les deuxièmes pixels formant un deuxième réseau du masque, le procédé comprenant en outre les étapes suivantes :

    a. Etablir une deuxième densité cible $D_{200}{}^*$ d'une deuxième densité surfacique $D_{200}$ de deuxièmes zones opaques au sein du deuxième réseau, la deuxième densité cible $D_{200}{}^*$ étant configurée pour permettre d'insoler la résine sur une deuxième épaisseur cible $e_2{}^*$ donnée lorsque la résine est exposée au rayonnement au travers du deuxième réseau du masque, la deuxième épaisseur cible $e_2^*$ étant mesurée selon la direction principale du rayonnement, la deuxième épaisseur cible $e_2^*$ étant distincte de la première épaisseur cible $e_1^*$,

b. Obtenir une deuxième valeur, pour la deuxième densité cible $D_{200}^*$, de la dérivée par rapport à la deuxième densité surfacique $D_{200}$ de la deuxième épaisseur $e_2$ sur laquelle la résine photosensible est insolée lorsqu'elle est exposée à un rayonnement au travers du deuxième réseau (200) présentant la deuxième densité surfacique $D_{200}$, notée

$$\frac{\partial e_2(D_{200}^*)}{\partial D_{200}},$$

c. Déterminer une deuxième dimension $P_{x,2}$ des deuxièmes pixels dans la première direction, une deuxième dimension $P_{y,2}$ des deuxièmes pixels dans la deuxième direction, une deuxième dimension $L_{x,2}$ des deuxièmes zones opaques dans la première direction, une deuxième dimension $L_{y,2}$ des deuxièmes zones opaques dans la deuxième direction, de façon à ce que la valeur d'une erreur sur la deuxième épaisseur cible $e_2^*$, notée $MEEF(e_2^*)$ soit inférieure à un deuxième seuil donné, $MEEF(e_2^*)$ étant calculé à partir de la formule suivante :

$$MEEF(e_2^*) = \frac{\partial e_2(D_{200}^*)}{\partial D_{200}} \frac{(a_2 + \beta_2)L_{x,2}}{P_{x,2}P_{y,2}}$$

Avec $\beta_2 = \frac{L_{y,2}}{L_{x,2}}$ et $a_2 = \frac{\delta L_{y,2}}{\delta L_{x,2}}$, $\delta L_{x,2}$ étant une erreur sur $L_{x,2}$ et $\delta L_{y,2}$ étant une erreur sur $L_{y,2}$,

d. Utiliser les dimensions obtenues pour le dimensionnement du deuxième réseau du masque.

Selon un exemple avantageux, le deuxième réseau forme dans le plan horizontal un contour fermé dans lequel se trouve le premier réseau.

Selon un exemple préféré, le contour fermé formé par le deuxième réseau est sensiblement circulaire. Cet exemple est particulièrement avantageux dans la fabrication de microlentilles. Selon un exemple, le deuxième seuil pour l'erreur sur la deuxième épaisseur cible $e_2^*$ est inférieur au premier seuil pour l'erreur sur la première épaisseur cible $e_1^*$.

Dans le cadre de la présente invention, on qualifie de résine un matériau organique ou organo-minéral pouvant être mis en forme par une exposition à un faisceau d'électrons, de photons, de rayons X, un faisceau de lumière dans la gamme des ultraviolets, des extrêmes ultraviolets (UEV) ou des ultraviolets profonds (Deep UV) typiquement dans la gamme de longueurs d'onde de 193 nm à 248 nm, les raies d'émissions d'une lampe mercure, soit : 365 nm pour la I line, 435 nm pour la G line et 404 nm pour la H line.

L'invention s'applique aussi bien aux résines positives, c'est-à-dire dont la partie exposée devient soluble au révélateur et où la partie non exposée reste insoluble, qu'aux résines négatives, c'est-à-dire dont la partie non exposée devient soluble au révélateur et où la partie exposée reste insoluble.

Le contraste d'une résine, couramment noté $\gamma$, traduit l'efficacité du comportement désigné dans la littérature comme « à seuil » de la résine. Plus le contraste est grand, plus une faible variation de dose est nécessaire pour que la résine passe d'un état dans lequel elle ne peut pas être développée à un état dans lequel elle peut être développée (ou inversement pour une résine négative). La valeur du contraste y d'une résine, qu'elle soit de tonalité positive ou négative, est généralement déterminée par la pente de la courbe selon l'équation suivante : $\frac{e}{e_0} = \gamma ln\left(\frac{D_0}{D}\right)$, où e est l'épaisseur du film de résine après exposition et développement, $e_0$ est l'épaisseur du film de résine initial, D est la dose d'exposition appliquée et $D_0$ est la dose à laquelle toute l'épaisseur du film est développée.

On entend par « nature » d'un matériau tel qu'une résine sa composition chimique, c'est-à-dire la nature et la proportion des espèces constituant le matériau. Deux couches sont considérées comme faites d'une même résine si elles présentent la même composition chimique.

Dans la présente description, on qualifie de dose une quantité d'énergie reçue par une résine par unité de surface. Cette énergie peut être sous forme de photons (photolithographie) pour une résine photosensible. Elle est alors le produit de l'intensité du rayonnement lumineux incident (généralement exprimée en Watt/m$^2$) et de la durée d'exposition (exprimée en secondes). La dose est alors habituellement exprimée en Joules par m$^2$, ou plus souvent en milli Joules (mJ) par cm$^{-2}$ ($10^{-4}$ m$^2$) ou encore en mJ/m$^2$. Cette énergie peut également être sous forme d'électrons (lithographie électronique) pour une résine électrosensible. La dose est alors habituellement exprimée en Coulombs par m2, ou plus souvent en micro Coulombs ($\mu$C) par cm$^{-2}$ ($10^{-2}$ m$^2$) soit en $\mu$C/m$^2$.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan horizontal XY. Ainsi, une couche présente typiquement une épaisseur selon la direction dite verticale Z, lorsqu'elle s'étend principalement le long du plan horizontal XY. Les termes relatifs « sur », « sous », « sous-jacent » se réfèrent préférentiellement à des positions prises selon la direction verticale Z.

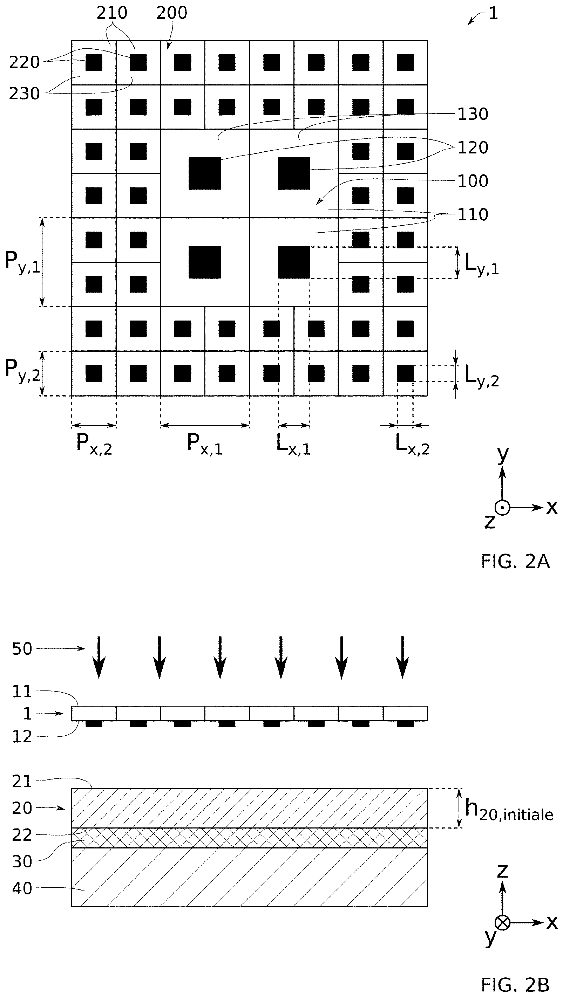

Un premier objet de la présente invention concerne un procédé de dimensionnement d'un masque 1 de lithographie à échelle de gris. Le masque 1 dimensionné à l'aide du procédé selon l'invention pourra être désigné « masque optimisé » ou « masque redimensionné ». Le masque 1 est représenté aux figures 2A et 2B. Il s'étend principalement selon un plan (dans l'exemple horizontal) XY défini par la première direction X et la deuxième direction Y. Plus précisément, il présente une face supérieure 11 et une face inférieure 12 s'étendant chacune sensiblement parallèlement au plan horizontal XY.

Lors de l'utilisation du masque 1, sa face inférieure 12 est placée en regard d'une face supérieure 21 d'une couche de résine 20, qui pourra également être désignée résine 20. La face supérieure 21 de la couche de résine 20 s'étend elle aussi parallèlement au plan horizontal XY. La couche de résine 20 repose typiquement sur un substrat support 40. Une sous-couche 30 peut être intercalée entre le substrat support 40 et la couche de résine 20. Lors de l'utilisation du masque 1, la couche de résine 20 est exposée à un rayonnement 50 au travers du masque 1. Ce rayonnement 50 présente une direction principale sensiblement perpendiculaire au plan horizontal XY. Le rayonnement 50 est typiquement un rayonnement UV (pour ultra-violet) ; il peut ainsi s'agir d'un rayonnement émettant dans une gamme de longueur d'onde allant d'environ 100 nm à environ 400 nm, par exemple 365 nm. Il peut cependant également s'agir d'un rayonnement présentant des longueurs d'ondes se trouvant en dehors de cette gamme. De façon générale, on peut envisager non limitativement un rayonnement émettant dans une gamme de longueur d'onde allant d'environ 90 nm à environ 500 nm.

Idéalement, la résine 20 utilisée présente au moins l'une des caractéristiques suivantes :

a. Une réponse sensiblement linéaire entre la dose de rayonnement à laquelle elle est exposée et l'épaisseur sur laquelle elle est insolée.

b. Un contraste suffisamment faible, par exemple inférieur à 2, pour permettre la mise en œuvre de la lithographie en échelle de gris, mais suffisamment élevé, par exemple supérieur à 1, pour éviter des temps d'exposition trop importants. Avantageusement, le contraste est compris entre 1,1 et 1,5.

c. De bonnes propriétés filmogènes, garanties par exemple par la présence d'un agent filmogène dans sa composition.

d. Une faible inhibition de la dissolution.

On peut notamment citer comme exemples de résines utilisables dans le contexte de l'invention les résines, produites par la société Micro Resist Technology portant les références commerciales ma-P 1215G, ma-P 1225G et ma-P 1275G.

Les paragraphes suivants visent à décrire plus précisément le masque 1 en référence à la figure 2A.

Comme cela est couramment réalisé lors de la conception d'un masque de lithographie, le masque 1 est divisé en une pluralité de pixels, parfois désignés cellules. Ces pixels ou cellules servent de repères dans le plan horizontal XY et n'ont pas de réalité physique autre qu'une zone du masque incluant une, et une seule, zone opaque. Chaque pixel définit un contour fermé théorique dans le plan horizontal XY dans lequel se trouvent une zone opaque et une zone transparente. Les zones opaques et les zones transparentes ont, elles, une réalité physique. Les zones transparentes correspondent à des régions du masque 1 dont la composition est transparente au rayonnement 50, tandis que les zones opaques correspondent à des régions du masque 1 dont la composition est opaque au rayonnement 50. Une zone est par exemple considérée comme opaque lorsqu'elle arrête au moins 90% du rayonnement 50 incident. Une zone est considérée comme transparente lorsqu'elle transmet au moins 60% du rayonnement 50 incident.

Par exemple, le masque 1 peut être un masque de verre avec des dépôts de chrome. Les zones opaques correspondent alors aux zones du masque 1 où du chrome a été déposé, tandis que les zones transparentes correspondent aux zones restées exemptes de chrome. Selon le principe de la lithographie à échelle de gris, pour une région donnée du masque 1, la densité surfacique D des zones opaques au sein de cette région détermine la dose de rayonnement reçue par la région de la couche de résine 20 sous-jacente et donc, par conséquent, l'épaisseur e sur laquelle cette région de la couche de résine 20 est insolée par le rayonnement 50. Cette densité D est typiquement modulée d'une région à l'autre du masque de façon à moduler spatialement l'épaisseur insolée dans la couche de résine 20. Pour une région donnée du masque 1, la densité surfacique D des zones opaques est le ratio entre la surface de la région occupée par les zones opaques et la surface totale de la région. Ces surfaces peuvent par exemple être évaluées au niveau de la face inférieure 12 du masque 1, sur laquelle sont typiquement réalisés les dépôts de matière (par exemple de chrome) formant les zones opaques.

La figure 2A illustre le cas de pixels disposés en réseaux carrés, mais il est envisageable que ces derniers soient d'un autre type. Il peut par exemple s'agir de formes de réseaux parmi un réseau triangulaire ou d'un réseau hexagonal.

La figure 2A illustre par ailleurs le cas de zones opaques de forme carrée dans le plan horizontal XY, mais il est entendu que d'autres formes sont envisageables. Les zones opaques peuvent par exemple être rectangulaires, circulaires, triangulaires ou encore hexagonales.

Le type de réseau selon lequel sont arrangés les pixels et la forme des zones opaques sont choisis de manière à obtenir la densité désirée au sein de chaque région du masque 1.

Comme illustré à la figure 2A, les zones opaques comprennent une pluralité de premières zones opaques 120 et les zones transparentes comprennent une pluralité de premières zones transparentes 130. La position de ces premières zones opaques 120 et de ces premières zones transparentes 130 est repérée par des premiers pixels 110. Les premiers pixels 110 forment ensemble un premier réseau 100 du masque 1. Ce premier réseau 100 correspond à une région du masque 1 telle que décrite précédemment. Le premier réseau 100 comprend typiquement plus de quatre premiers pixels 110.

Le réseau 100 est de préférence d'un seul tenant. Autrement dit, de préférence, tous les pixels 110 du réseau 100 se trouvent d'un seul tenant. Le réseau 100 peut éventuellement présenter en projection dans le plan horizontal XY une forme creuse.

Chaque premier pixel 110 définit un contour fermé dans lequel se trouve une première zone opaque 120 et une première zone transparente 130.

Au sein du premier réseau 100, les premiers pixels 110 présentent tous la même forme et les mêmes dimensions. Selon la première direction X, les premiers pixels 110 présentent une première dimension $P_{x,1}$ et les premières zones opaques 120 une première dimension $L_{x,1}$. Selon la deuxième direction Y, les premiers pixels 110 présentent une deuxième dimension $P_{y,1}$ et les premières zones opaques 120 une deuxième dimension $L_{y,1}$. Par ailleurs, au sein du premier réseau 100, les premières zones opaques 120 se trouvent toutes à une même position relativement au pixel 110 qui les entoure. De préférence, les premières zones opaques 120 sont centrées dans les pixels 110.

Le masque 1 présente avantageusement un deuxième réseau 200 de deuxièmes pixels 210 comprenant chacun une deuxième zone opaque 220 et une deuxième zone transparente 230. Au sein du deuxième réseau 200, les deuxièmes pixels 210 présentent tous la même forme et les mêmes dimensions. Selon la première direction X, les deuxièmes pixels 210 présentent une première dimension $P_{x,2}$ et les deuxièmes zones opaques 220 une première dimension $L_{x,2}$. Selon la deuxième direction Y, les deuxièmes pixels 210 présentent une deuxième dimension $P_{y,2}$ et les deuxièmes zones opaques 220 une deuxième dimension $L_{y,2}$.

Les positions relatives du premier réseau 100 et du deuxième réseau dépendent de la forme de la structure 3D que l'on souhaite fabriquer. Selon un mode de réalisation trouvant de nombreuses applications, le deuxième réseau 200 forme un contour fermé dans le plan horizontal XY et le premier réseau 100 est contenu dans ce contour fermé. Avantageusement, ce contour fermé présente une forme sensiblement circulaire. Par exemple, le deuxième réseau 200 peut présenter dans le plan horizontal XY la forme d'une couronne circulaire et le premier réseau 100 celle d'un disque, le premier réseau 100 et le deuxième réseau 200 étant de préférence concentriques. Ce dernier cas permet notamment de former une microlentille. De préférence, plus de deux réseaux sont utilisés pour former une microlentille.

Il est à noter que les pixels présentant typiquement des bords droits, il est impossible que les réseaux présentent des formes parfaitement courbes, et notamment parfaitement circulaires. Les formes décrites pour les réseaux du masque s'entendent donc comme des formes générales dont la pixellisation doit être négligée.

Il est entendu que le masque 1 peut présenter autant de réseaux de pixels et zones opaques que les applications visées le requièrent. Toutes les caractéristiques décrites pour le premier réseau s'appliquent mutatis mutandis au deuxième réseau et à tout autre réseau supplémentaire. Ce qui distinguera un réseau d'un autre sera typiquement la densité de zones opaques en son sein et donc l'épaisseur de résine qui sera insolée lorsque cette dernière sera exposée à un rayonnement au travers du réseau. Autrement dit, les différents réseaux du masque 1 permettront typiquement de former des régions de hauteurs différentes au sein de la structure 3D réalisée dans la résine 20. Il n'est pas exclu cependant que deux réseaux présentent la même densité de zones opaques et permettre donc de former des régions de même hauteur dans la résine 20. Des réseaux présentant la même densité de zones opaques peuvent être juxtaposés ou non, en fonction des structures 3D à former.

Comme énoncé dans la partie introductive, un objectif de l'invention est de proposer une solution d'amélioration de la résolution selon la direction verticale Z des structures 3D formées. Les paragraphes suivants visent tout d'abord à montrer comment est établie l'erreur sur l'épaisseur de résine insolée (ou la hauteur de la résine après développement), mesurée selon la direction verticale Z, à partir des dimensions dans le plan horizontal XY des pixels et des zones opaques.

Dans le cas générique d'un masque 1 comprenant N zones opaques de dimensions $L_{x,i}$, $L_{y,i}$ (i variant de 1 à N), chaque zone opaque se trouvant au sein d'un pixel de dimensions $P_x$, $P_y$, la densité théorique ($D_{masque,\,théorique}$) de zones opaques au sein du masque est donnée par la formule suivante :

[Math 1]

$$D_{masque,théorique} = \frac{\sum_{i=1}^{N} L_{x,i} L_{y,i}}{N P_x P_y}$$

Cette formule ne prend pas en compte de potentielles erreurs de fabrication du masque 1. De telles erreurs peuvent en effet avoir pour conséquence des variations sur les dimensions des zones opaques par rapport aux valeurs visées. En revanche, les pixels n'ayant pas de réalité physique, il est raisonnable de considérer qu'ils ne peuvent pas faire l'objet d'erreurs de fabrication. En notant $\delta L_{x,i}$ et $\delta L_{y,i}$ les erreurs sur la première dimension $L_{x,i}$ et la deuxième dimension $L_{y,i}$ respectivement des zones opaques, la densité réelle de zones opaques au sein du masque est donnée par la formule suivante :

[Math 2]

$$D_{masque,réel} = \frac{\sum_{i=1}^{N} (L_{x,i} + \delta L_{x,i})(L_{y,i} + \delta L_{y,i})}{N P_x P_y}$$

Par ailleurs, il est courant d'estimer que l'erreur $\delta L_{x,i}$ sur la dimension $L_{x,i}$ selon X des zones opaques et l'erreur $\delta L_{y,i}$ sur la dimension $L_{y,i}$ selon Y des zones opaques sont proportionnelles :

[Math 3]

$$\delta L_{y,i} = a_i \delta L_{x,i}$$

En faisant cette hypothèse, la relation Math 2 peut être réécrite comme il suit :

[Math 4]

$$D_{masque,réel} = D_{masque,théorique} + \frac{\sum_{i=1}^{N} \delta L_{x,i}(a_i L_{x,i} + L_{y,i})}{N P_x P_y}$$

Ainsi, l'erreur du la densité de zones opaques au sein du masque 1 peut être calculée comme il suit, en considérant que l'erreur $\delta L_{x,i}$ sur la première dimension $L_{x,i}$ des zones opaques est la même pour toutes les zones opaques :

[Math 5]

$$\delta D_{masque} = D_{masque,théorique} - D_{masque,réel} = \delta L_x \frac{\sum_{i=1}^{N} (a_i L_{x,i} + L_{y,i})}{N P_x P_y}$$

Dans le cas de zones opaques présentant toutes les mêmes dimensions ($L_{x,i}=L_x$ et $L_{y,i}=L_y$ pour tout i, et donc $a_i=a$ pour tout i), il est possible d'établir un lien de proportionnalité entre leur dimension selon la première direction et leur dimension selon la deuxième direction :

[Math 6]

$$L_y = \beta L_x$$

Dans ce cas, l'erreur $MEEF_z$ selon la direction verticale Z sur la hauteur h de résine restante après développement est donnée par la formule suivante :

[Math 7]

$$MEEF_Z = \frac{\partial h}{\partial D_{masque}} \frac{(a + \beta) L_x}{P_x P_y}$$

Si l'on considère que les pixels ont tous dans le plan XY la forme d'un carré de côté P ($P_x=P_y=P$) et que les zones opaques ont toutes dans le plan XY la forme d'un carré de côté L ($L_x=L_y=L$), alors l'erreur $MEEF_Z$ selon la direction verticale Z sur la hauteur h de résine restante après développement est donnée par la formule suivante :

[Math 8]

$$MEEF_Z = \frac{\partial h}{\partial D_{masque}} \frac{(a+1)\sqrt{D_{masque,théorique}}}{P}$$

Car alors, $\beta=1$.

La formule Math 8 montre qu'il est possible de moduler l'erreur $MEEF_Z$ en faisant varier les dimensions des pixels du réseau.

Par ailleurs, en supposant que a=1 (i.e. que l'erreur $\delta L_{x,i}$ sur la première dimension $L_{x,i}$ des zones opaques et l'erreur $\delta L_{y,i}$ sur la deuxième dimension $L_{y,i}$ des zones opaques sont égales), on peut simplifier encore la formule Math 8 :

[Math 9]

$$MEEF_Z = \frac{\partial h}{\partial D_{masque}} \frac{2\sqrt{D_{masque,théorique}}}{P}$$

Il est à noter que pour caractériser l'impact de l'insolation sur la résine, on peut considérer deux dimensions complémentaires, toutes les deux mesurées selon la directions verticales Z :

    a. L'épaisseur e sur laquelle la résine est insolée, avant développement,
    b. La hauteur h de la résine restante après développement de la portion insolée.

e et h sont liées de façon très directe par la relation $h=h_{20,initiale}-e$, avec $h_{20,initiale}$ la hauteur de la résine 20 avant l'étape de développement. Ainsi, « déterminer e » peut passer par la mesure de h, et inversement. Par ailleurs, étant donnée la relation existante entre h et e, l'erreur sur e est sensiblement égale à l'erreur sur h. On notera ainsi indifféremment $MEEF_Z$, MEEF(h) ou MEEF(e).

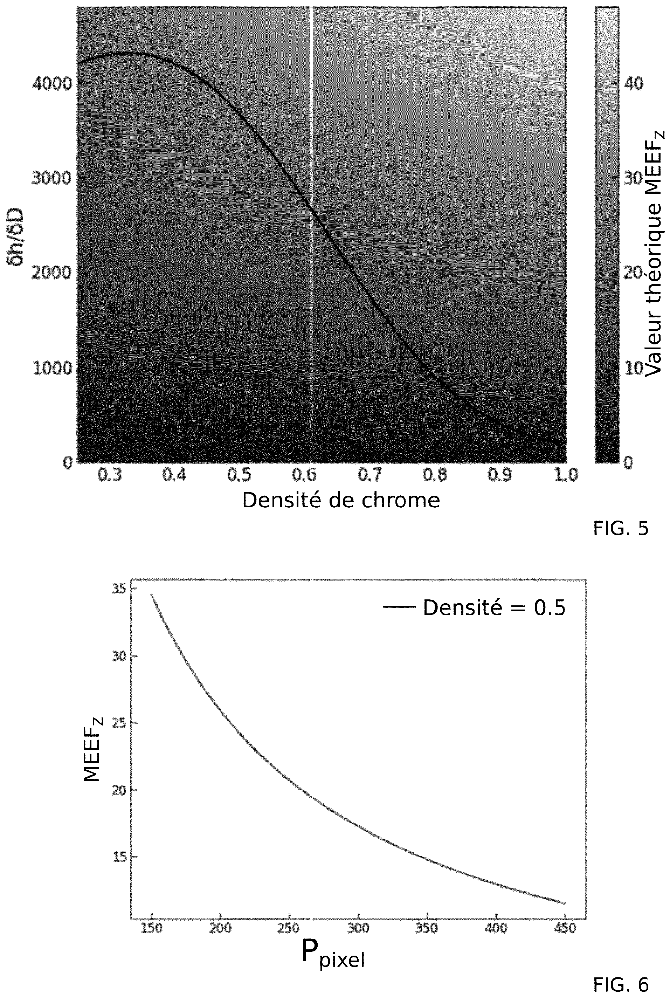

La figure 5 illustre l'évolution de la valeur de $MEEF_Z$ en fonction du paramètre $\delta h/\delta D_{masque}$ et de la densité de zones opaques au niveau du masque, et ce pour des dimensions de pixels fixées. La courbe tracée correspond aux valeurs de $MEEF_Z$ obtenues pour une structure donnée. On observe que $MEEF_Z$ augmente lorsque la densité de zones opaques diminue. Il est donc tout particulièrement crucial de trouver une solution pour réduire $MEEF_Z$ pouvant s'appliquer pour de faibles valeurs de densités.

La figure 6 illustre l'évolution de la valeur de $MEEF_Z$ en fonction de la longueur du côté des pixels (ici les pixels sont carrés), et ce pour une densité de zones opaques fixée. On observe que plus le côté des pixels est grand, plus $MEEF_Z$ est faible. On en déduit donc que pour améliorer la résolution en Z des structures 3D, augmenter les dimensions des pixels est une solution efficace. Cette solution apparaît d'autant plus intéressante qu'elle est applicable pour toute valeur de densité, et notamment pour des valeurs de densité faibles, qui posent particulièrement problème (voir figure 5).

Ainsi, on définit typiquement un seuil minimal pour $MEEF_Z$, correspondant à une dimension minimale des pixels, afin de garantir une bonne résolution selon la direction verticale Z.

On note qu'une augmentation trop importante des dimensions des pixels peut provoquer une diminution de la résolution dans le plan horizontal XY au-delà de niveaux acceptables. Ainsi, un seuil maximal pour $MEEF_Z$ peut être utilisé en complément du seuil minimal pour satisfaire une résolution selon la première direction X et une résolution dans la deuxième direction Y satisfaisantes.

Notamment, si une dimension des zones opaque (selon la première direction X ou la deuxième direction Y) est supérieure ou égale à la longueur d'onde principale du rayonnement 50, alors les zones opaques risquent d'être résolues et leur forme risque d'être transférée à la structure 3D formée par lithographie à échelle de gris à l'aide du masque 1. Ainsi, avantageusement, $P_x$ et $P_y$ (P dans le cas de pixels carrés) sont inférieurs à la longueur d'onde principale du rayonnement 50. Le seuil maximal pour $MEEF_Z$ peut correspondre à une valeur garantissant cela.

Dans le cas d'un rayonnement monochromatique, la longueur d'onde principale s'entend comme l'unique longueur d'onde représentée. Dans le cas d'un rayonnement polychromatique couvrant un intervalle de longueurs d'onde, la longueur d'onde principale peut être la longueur d'onde se trouvant au milieu de cet intervalle.

Méthode d'élaboration d'un abaque liant densité de zones opaques et épaisseur insolée à l'aide d'un masque test

Les paragraphes ci-dessous présentent une première méthode par laquelle il est possible d'obtenir un abaque liant densité de zones opaques et épaisseur insolée dans la résine (ou hauteur de la résine après développement). Cette méthode est privilégiée lorsque l'on dispose d'un masque de lithographie dit « masque test » pouvant servir à réaliser des tests en vue du dimensionnement du masque optimisé grâce à la méthode selon l'invention. Il est entendu que toute autre méthode peut être mise en œuvre pour obtenir les mêmes données.

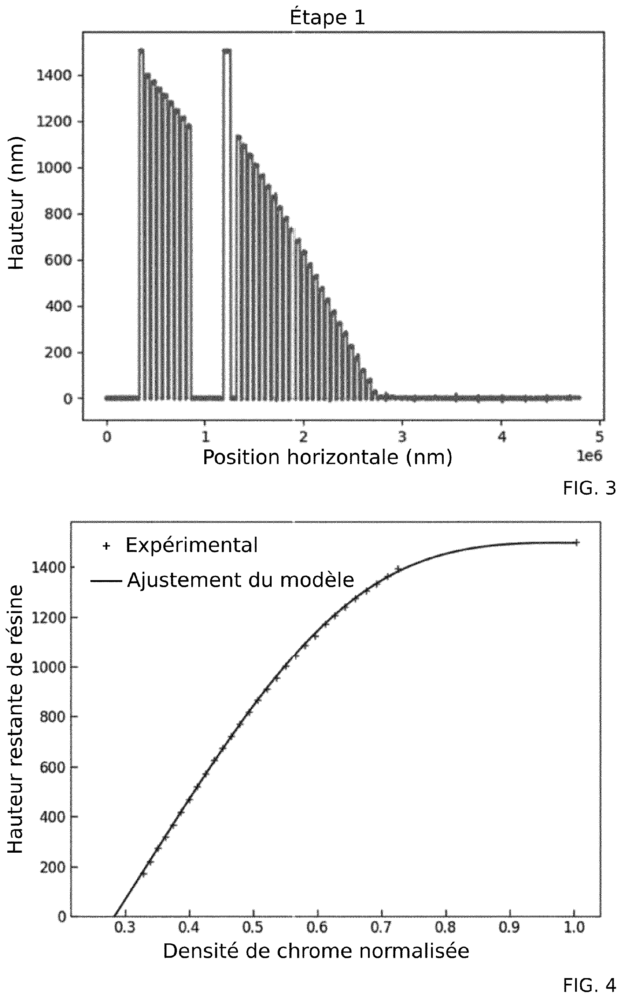

Les différentes étapes de cette méthode sont illustrées aux figures 3 et 4.

Tout d'abord, un masque test présentant plusieurs réseaux distincts, dits réseaux tests, est utilisé pour insoler une couche de résine test de même nature que celle qui sera utilisée en association avec le masque optimisé (couche de résine 20). Les différents réseaux du masque présentent chacun une densité de zones opaques différente. Après développement, on mesure la hauteur de résine obtenue pour chaque densité de zones opaque. Les résultats expérimentaux obtenus sont illustrés en figure 3.

On établit ensuite, à partir des points expérimentaux obtenus grâce au masque test, une courbe de tendance reliant la densité D de zones opaques au niveau d'un masque théorique et la hauteur h de résine après développement lorsque la résine a été insolée au travers de ce masque. Les points expérimentaux issus de l'étape précédente ainsi que le modèle établi à partir de ces points sont représentés sur le graphique de la figure 4. Cette courbe de tendance, qui correspond à une courbe de contraste, est continue et permet d'estimer la relation entre h et D pour des valeurs de densité n'étant pas présentes sur le masque test.

La dérivée de la fonction correspondant à cette courbe de tendance traduit l'impact d'une variation de la densité de zones opaques sur la hauteur de la résine après développement. Cette valeur entre en jeu dans la détermination de l'erreur sur la hauteur de la résine après développement (voir formule Math 7).

Ainsi, à l'aide de simples tests à l'aide d'un masque test et d'une résine test de même nature que la résine 20 qui sera employée avec le masque optimisé, on peut obtenir un paramètre clef pour le dimensionnement de ce masque optimisé.

Méthode d'élaboration d'un abaque liant densité de zones opaques et épaisseur insolée ne nécessitant pas de masque test

Les paragraphes ci-dessous présentent une deuxième méthode par laquelle il est possible d'obtenir un abaque liant densité de zones opaques et épaisseur insolée dans la résine (ou hauteur de la résine après développement). Cette méthode est privilégiée lorsque l'on ne dispose pas de masque de lithographie pouvant servir à réaliser des tests en vue du dimensionnement du masque optimisé grâce à la méthode selon l'invention. Il est entendu que toute autre méthode peut être mise en œuvre pour obtenir les mêmes données.

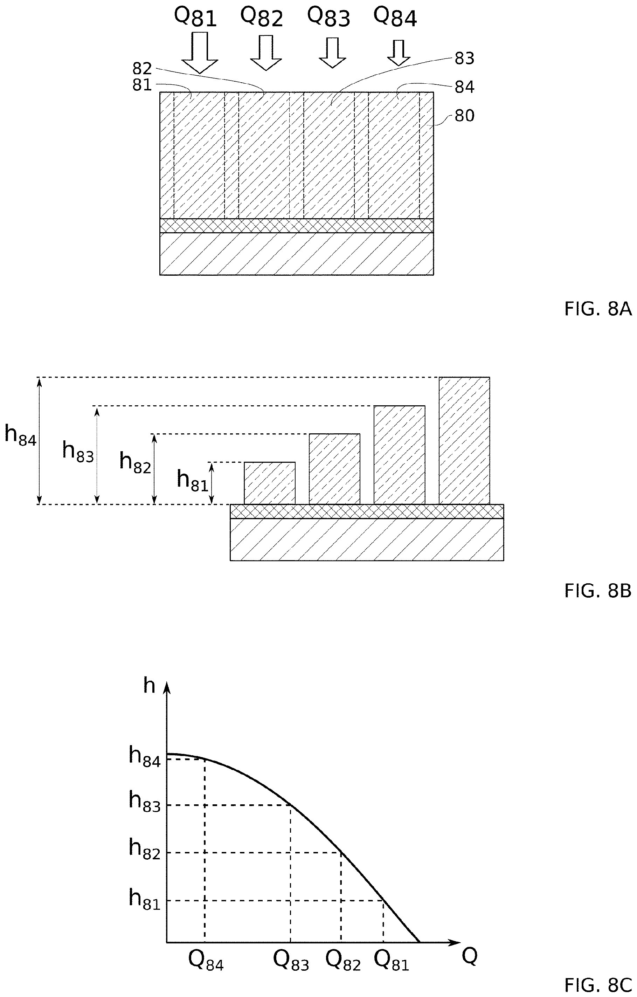

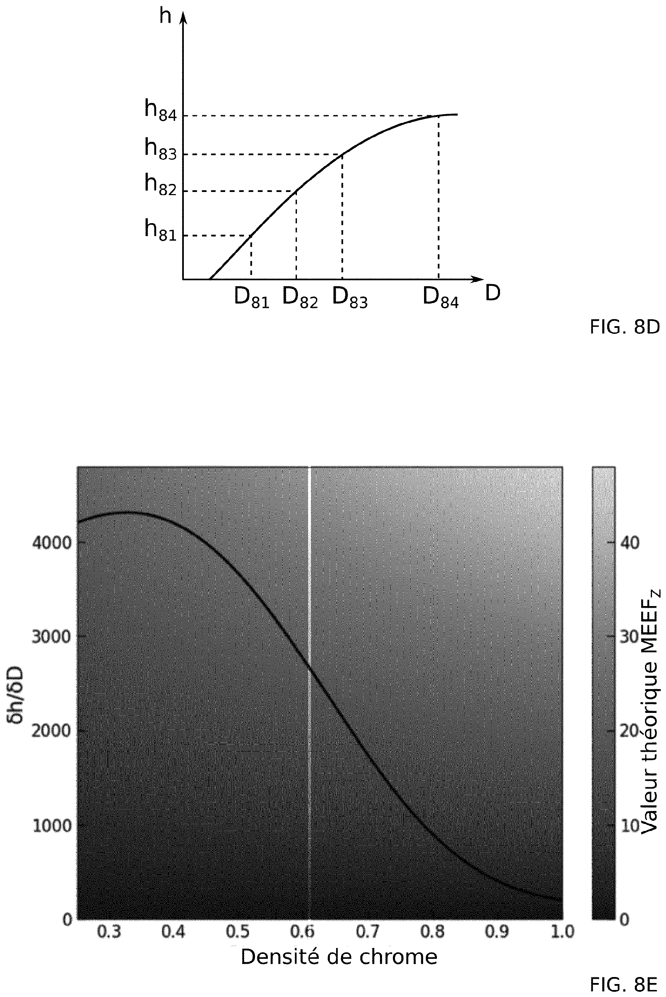

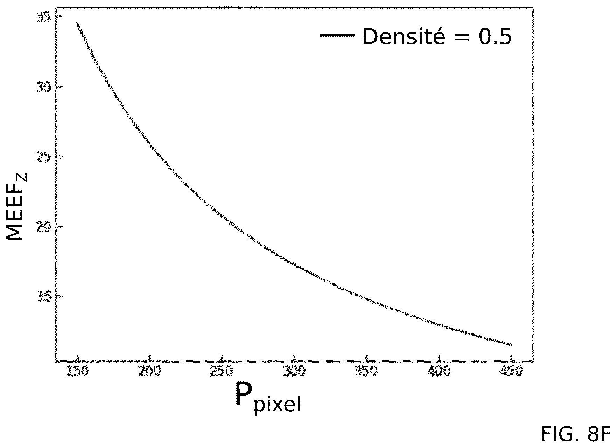

Les différentes étapes de cette méthode sont illustrées aux figures 8A à 8F.

La figure 8A illustre la fourniture d'un empilement comprenant une couche de résine secondaire 80 de même nature que celle qui sera utilisée en association avec le masque optimisé (couche de résine 20). La couche de résine secondaire 80 est exposée à partir de sa face supérieure à un rayonnement d'insolation. Différentes zones 81, 82, 83, 84 de la résine 80 sont insolées avec différentes doses $Q_{81}$, $Q_{82}$, $Q_{83}$, $Q_{84}$, induisant chacune une certaine épaisseur e de résine insolée. De ce fait, après développement (figure 8B) de la résine exposée, la couche de résine secondaire 80 présente différentes hauteurs $h_{81}$, $h_{82}$, $h_{82}$, $h_{83}$, au niveau des différentes zones 81, 82, 83, 84. On peut ainsi associer à chaque dose une hauteur de résine obtenue après développement.

On peut ensuite établir, à partir des points expérimentaux ainsi obtenus, une courbe de tendance mettant en lien la dose appliquée à la résine et la hauteur de la résine après développement (figure 8C).

Il est par ailleurs possible de déterminer, pour chaque zone i de la résine 80, la densité théorique $D_i$ de zones opaques au niveau d'un masque théorique qui aurait permis d'insoler la zone en question, lors de son insolation au travers du masque théorique, avec une dose $Q_i$ qu'elle a effectivement reçue lors de l'étape d'étalonnage illustrée à la figure 8A. La formule suivante permet de calculer cette densité $D_i$, $Q_i$ correspondant à la dose de rayonnement reçue par la zone i lors de l'étape d'étalonnage (figure 8A), et $Q_{max}$ correspondant à la dose de rayonnement ayant été reçue par la zone de la résine secondaire 80 ayant été la plus insolée (dans l'exemple illustré à la figure 8A, $Q_{max}=Q_{81}$) :

[Math 10]

$$D_i = 1 - \frac{Q_i}{Q_{max}}$$

On fait donc l'hypothèse que pour $Q_i=Q_{max}$, la densité de zones opaques au niveau du masque théorique est nulle. Cela revient à considérer que lors de l'utilisation de ce masque théorique, à temps d'exposition $t_{expo}$ égal, l'intensité

$I_0$ du rayonnement avant son passage au travers du masque correspond à l'intensité $I_{max}$ permettant d'obtenir la dose $Q_{max}$ (c'est-à-dire : $I_0=I_{max}$ avec $I_{max}=Q_{max}/t_{expo}$).

Grâce à la formule ci-dessus et aux points expérimentaux obtenus par étalonnage, on peut établir une courbe de tendance reliant la densité D de zones opaques au niveau du masque théorique et la hauteur h de résine après développement lorsque la résine a été insolée au travers de ce masque (figure 8D). Cette courbe de tendance, qui correspond à une courbe de contraste, est continue et permet d'estimer la relation entre h et D pour des valeurs de doses (et donc de densités théoriques) non testées lors de l'étalonnage.

La dérivée de la fonction correspondant à cette courbe de tendance traduit l'impact d'une variation de la densité de zones opaques sur la hauteur de la résine après développement. Cette valeur entre en jeu dans la détermination de l'erreur sur la hauteur de la résine après développement (voir formule Math 7).

Ainsi, à l'aide d'un simple étalonnage sur une résine secondaire 80 de même nature que la résine 20 qui sera employée avec le masque optimisé, on peut obtenir un paramètre clef pour le dimensionnement de ce masque optimisé.

Premier exemple de mise en œuvre du procédé de dimensionnement selon l'invention

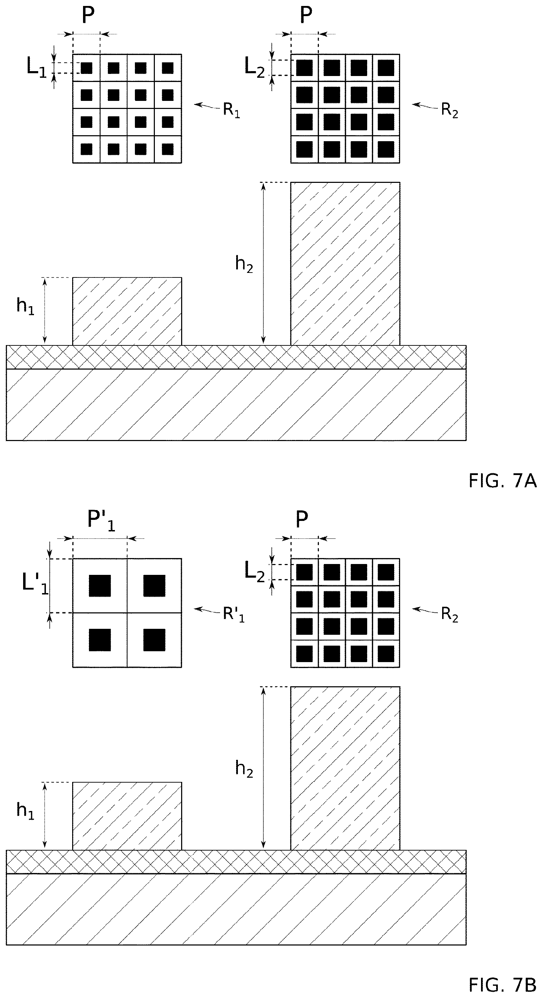

Les figures 7A et 7B illustrent la façon dont le procédé selon l'invention peut être employé pour redimensionner un masque de lithographie à échelle de gris présentant une résolution en Z insatisfaisante.

La figure 7A illustre deux réseaux $R_1$, $R_2$ d'un même masque 1 (ou éventuellement de deux masques 1 distincts) utilisés pour insoler une couche de résine sur deux épaisseurs distinctes, et donc former dans la couche de résine, une fois celle-ci développée, deux régions de hauteurs $h_1$ et $h_2$ distinctes. Les hauteurs $h_1$ et $h_2$ sont obtenues en dimensionnant les masques pour qu'ils présentent la densité surfacique de zones opaques adéquate. Dans la figure 7A, les dimensions des pixels et des zones opaques ont été choisies arbitrairement, avec pour seule contrainte la nécessité que la densité surfacique de zones opaques permette d'obtenir la hauteur de résine souhaitée. Les deux réseaux présentent des pixels carrés de côté P. Le réseau $R_1$ donnant une hauteur de résine $h_1$ présente des zones opaques carrées de côté $L_1$, tandis que le réseau $R_2$ donnant une hauteur de résine $h_2$ présente des zones opaques carrés de côté $L_2$.

Le procédé selon l'invention permet de déterminer quelles sont les dimensions idéales des deux réseaux $R_1$, $R_2$ pour limiter l'erreur sur les hauteurs de résine $h_1$, $h_2$. D'après les résultats du procédé, concernant le réseau $R_1$, il est nécessaire, pour atteindre les niveaux de précision souhaités, d'affecter aux pixels un côté $P_1'$ avec $P_1'>P$ et aux zones opaques un côté $L_1'$ avec $L_1'>L_1$. Naturellement, pour que la hauteur $h_1$ soit la même avant et après dimensionnement, on a $L_1^2/P^2=L_1'^2/P_1'^2$. En écrivant $L_1'= \alpha L_1$ et $P_1'=\alpha P_1$, on peut établir un facteur d'échelle $\alpha$.

Concernant le réseau $R_2$, on trouve, par application du procédé selon l'invention, que les dimensions P et $L_2$ induisent une erreur selon z satisfaisante. Ces dimensions peuvent donc être conservées pour le dimensionnement du masque optimisé 1.

Ainsi, le passage de la figure 7A à la figure 7B illustre un redimensionnement du masque 1 permettant d'obtenir les mêmes structures 3D au niveau de la résine photosensible, mais en garantissant une erreur plus faible dans la direction verticale Z.

Deuxième exemple de mise en œuvre du procédé de dimensionnement selon l'invention

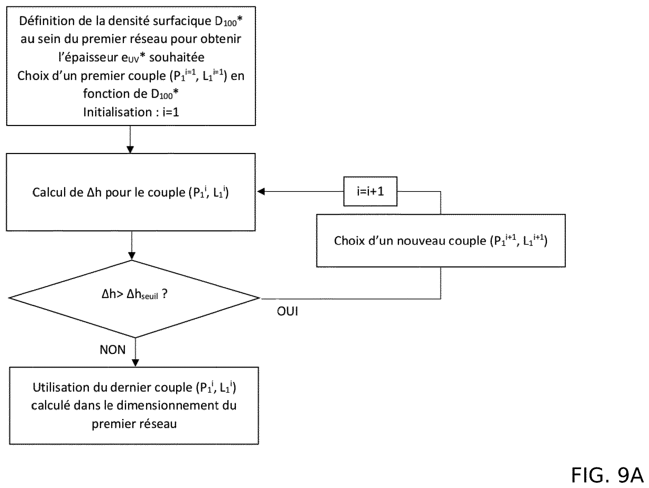

Les paragraphes suivants décrivent, en référence au logigramme présenté en figure 9A, une séquence d'étapes permettant le dimensionnement du premier réseau 100 du masque 1. Ces séquences sont décrites pour des premiers pixels 110 et des premières zones opaques 120 de forme carrée, mais il est entendu qu'il peut être adapté à toute autre forme de premiers pixels 110 et de premières zones opaques 120.

a. Bloc 1001 : Dans cette étape, on définit la première densité cible $D_{100}*$ permettant d'insoler la résine photosensible sur la première épaisseur cible e*. On choisit ensuite premier un couple de valeurs $(P_1^{i=1}, L_1^{i=1})$ pour le côté $P_1$ des premiers pixels 110 et pour le côté $L_1$ des zones opaques 120. Un compteur i repérant les couples de valeurs est initialisé (i=1).

b. Bloc 1002 : On calcule l'erreur $\Delta h$ sur la première épaisseur cible e* pour le couple $(P_1^i, L_1^i)$.

c. Bloc 1003 : On compare l'erreur $\Delta h$ obtenue à l'étape précédente par rapport à un seuil d'erreur $\Delta h_{seuil}$ préalablement fixé. Si l'erreur obtenue est supérieure à ce seuil, on passe à l'étape décrite au bloc 1004. Sinon, on passe à l'étape décrite au bloc 1005.

d. Bloc 1004 : L'erreur sur la première épaisseur cible e* pour le couple $(P_1^i, L_1^i)$ n'étant pas satisfaisante, on choisit un nouveau couple de valeurs $(P_1^{i+1}, L_1^{i+1})$ pour le côté $P_1$ des premiers pixels 110 et pour le côté $L_1$ des zones opaques 120, avec $P_1^{i+1}>P_1^i$ et en respectant $(L_1^i)^2/(P_1^i)^2= (L_1^{i+1})^2/(P_1^{i+1})^2$ pour conserver la même densité de zones opaques 120. On repasse ensuite au bloc 1002. A chaque passage du bloc 1004 au bloc 1002, on incrémente i de 1.

e. Bloc 1005 : L'erreur sur la première épaisseur cible e* pour le couple qui a fait l'objet du dernier calcul au bloc 1002 est satisfaisante. Ce couple peut donc être conservé pour le dimensionnement du premier réseau 100 du masque 1.

<u>Troisième exemple de mise en œuvre du procédé de dimensionnement selon l'invention</u>

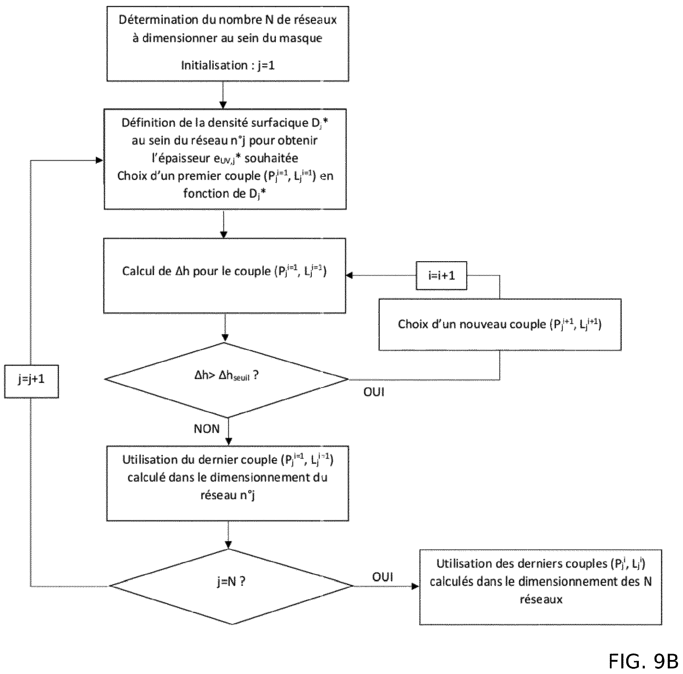

Les paragraphes suivants décrivent, en référence au logigramme présenté en figure 9B, une séquence d'étapes permettant le dimensionnement du masque 1 lorsque celui-ci comprend N réseaux. Ces séquences sont décrites pour des pixels et des zones opaques de forme carrée, mais il est entendu qu'elles peuvent être adaptées à toute autre forme de pixels et de zones opaques.

a. Bloc 2001 : Dans cette première étape, on détermine le nombre N de réseaux à dimensionner au sein du masque. Un compteur j repérant ces N réseaux est initialisé (j=1).

b. Bloc 2002 : Dans cette étape, on définit la densité cible $D_j$* du réseau n°j permettant d'insoler la résine photosensible sur l'épaisseur cible $e_j$*. On choisit ensuite un premier couple de valeurs ($P_j^{i=1}$, $L_j^{i=1}$) pour le côté $P_j$ des pixels du réseau n°j et pour le côté $L_j$ des zones opaques du réseau n°j.

c. Bloc 2003 : On calcule ensuite l'erreur $\Delta h$ sur l'épaisseur cible $e_j$* pour le couple ($P_j^i$, $L_j^i$).

d. Bloc 2004 : On compare l'erreur $\Delta h$ obtenue à l'étape précédente par rapport à un seuil d'erreur $\Delta h_{seuil}$ préalablement fixé. Si l'erreur obtenue est supérieure à ce seuil, on passe à l'étape décrite au bloc 2005. Sinon, on passe à l'étape décrite au bloc 2006.

e. Bloc 2005 : L'erreur sur la première épaisseur cible $e_j$* pour le couple ($P_1^i$, $L_1^i$) n'étant pas satisfaisante, on choisit un nouveau couple de valeurs ($P_1^{i+1}$, $L_1^{i+1}$) pour le côté $P_j$ des pixels du réseau n°j et pour le côté $L_j$ des zones opaques du réseau n°j, avec $P_j^{i+1} > P_j^i$ et en respectant $(L_j^i)^2/(P_j^i)^2 = (L_j^{i+1})^2/(P_j^{i+1})^2$ pour conserver la même densité de zones opaques au sein du réseau n°j. On passe ensuite au bloc 2003. À chaque passage du bloc 2005 au bloc 2003, on incrémente i de 1.

f. Bloc 2006 : L'erreur sur la première épaisseur cible $e_j$* pour le couple qui a fait l'objet du dernier calcul au bloc 2003 est satisfaisante. Ce couple peut donc être conservé pour le dimensionnement du réseau n°j du masque 1.

g. Bloc 2007 : On vérifie si j=N. Si ce n'est pas le cas, on incrémente j de 1 et on retourne au bloc 2002. Si c'est le cas, on passe au bloc 2008.

h. Bloc 2008 : Les N réseaux ont été dimensionnés. Le masque dans sa globalité peut être dimensionné.

L'invention n'est pas limitée aux modes de réalisations précédemment décrits et s'étend à tous les modes de réalisation couverts par l'invention telle que définie dans les revendications ci-dessous. Notamment, la mise en oeuvre du procédé selon l'invention n'est pas limitée à la fabrication de microlentilles et peut naturellement permettre la fabrication de structures 3D aussi diverses que des piliers, des cônes, des réseaux obliques (« slanted gratings » en anglais) et des structures en escalier.

## Revendications

**1.** Procédé de dimensionnement d'un masque (1) de lithographie en échelle de gris, le masque (1) s'étendant principalement selon un plan horizontal (XY) défini par une première direction (X) et une deuxième direction (Y), le plan étant perpendiculaire à une direction principale d'un rayonnement d'insolation d'une résine photosensible (20) au travers du masque (1), le masque (1) comprenant une pluralité de zones opaques au rayonnement, chaque zone opaque se situant dans une zone du masque (1) dite pixel, la pluralité de zones opaques comprenant des premières zones opaques (120) se trouvant dans des premiers pixels (110), les premiers pixels (110) formant un premier réseau (100) du masque (1), le procédé comprenant les étapes suivantes :

• Etablir une première densité cible $D_{100}$* d'une première densité surfacique $D_{100}$ de premières zones opaques (120) au sein du premier réseau (100), la première densité cible $D_{100}$* étant configurée pour permettre d'insoler la résine (20) sur une première épaisseur cible $e_1$* donnée lorsque la résine (20) est exposée au rayonnement au travers du premier réseau (100) du masque (1), la première épaisseur cible $e_1$* étant mesurée selon la direction principale du rayonnement,

• Obtenir une première valeur, pour la première densité cible $D_{400}$*, de la dérivée par rapport à la première densité surfacique $D_{100}$ de la première épaisseur $e_1$ sur laquelle la résine photosensible (20) est insolée lorsqu'elle est exposée à un rayonnement au travers du premier réseau (100) présentant la première densité surfacique $D_{400}$,

ladite première valeur étant notée $\dfrac{\partial e_1(D_{100}{}^*)}{\partial D_{100}}$,

• Déterminer une première dimension $P_{x,1}$ des premiers pixels (110) dans la première direction (X), une première dimension $P_{y,1}$ des premiers pixels (110) dans la deuxième direction (Y), une première dimension $L_{x,1}$ des premières zones opaques (120) dans la première direction (X), une première dimension $L_{y,1}$ des premières zones opaques (120) dans la deuxième direction (Y), de façon à ce que la valeur d'une erreur sur la première épaisseur cible $e_1{}^*$, notée $MEEF(e_1{}^*)$, soit inférieure à un premier seuil donné, $MEEF(e_1{}^*)$ étant calculée à partir de la formule suivante :

$$MEEF(e_1{}^*) = \frac{\partial e_1(D_{100}{}^*)}{\partial D_{100}} \frac{(a_1 + \beta_1)L_{x,1}}{P_{x,1}P_{y,1}}$$

Avec $\beta_1 = \frac{L_{y,1}}{L_{x,1}}$ et $a_1 = \frac{\delta L_{y,1}}{\delta L_{x,1}}$, $\delta L_{x,1}$ étant une erreur sur $L_{x,1}$ et $\delta L_{y,1}$ étant une erreur sur $L_{y,1}$,

• Utiliser les dimensions obtenues pour le dimensionnement du premier réseau (100) du masque (1).

2. Procédé selon la revendication précédente dans lequel $a_1$ est compris entre 0,8 et 1,2, de préférence a est égal à 1.

3. Procédé selon l'une quelconque des revendications précédentes dans lequel l'étape d'obtention de la première valeur de la dérivée comprend les étapes suivantes :

• Fournir une résine secondaire (80) de même nature que la résine photosensible (20),
• Insoler une pluralité de régions (81, 82, 83, 84) de la résine secondaire (80) avec un rayonnement, chaque région (81, 82, 83, 84) étant insolée avec une dose ($Q_{81}$, $Q_{82}$, $Q_{83}$, $Q_{84}$) de rayonnement distincte,
• Pour chaque région (81, 82, 83, 84) de la résine secondaire (80), déterminer selon la direction principale du rayonnement une épaisseur d'insolation du rayonnement dans ladite région (81, 82, 83, 84),
• Etablir, pour chaque région (81, 82, 83, 84) de la résine secondaire (80), une densité théorique ($D_{81}$, $D_{82}$, $D_{83}$, $D_{84}$) de zones opaques théoriques sur un masque théorique, qui, lors de l'exposition à un rayonnement de ladite région (81, 82, 83, 84) au travers du masque théorique, aurait permis d'exposer ladite région à la dose ($Q_{81}$, $Q_{82}$, $Q_{83}$, $Q_{84}$) de rayonnement à laquelle ladite région (81, 82, 83, 84) est exposée,
• Etablir un modèle reliant l'épaisseur d'insolation de la couche de résine secondaire (80) à la densité de zones opaques à partir des données d'épaisseur d'insolation et de densité théorique ($D_{81}$, $D_{82}$, $D_{83}$, $D_{84}$) obtenues pour chacune des régions (81, 82, 83, 84).

4. Procédé selon la revendication précédente dans lequel l'étape d'établissement, pour chaque région (81, 82, 83, 84) de la résine secondaire (80), de la densité théorique ($D_{81}$, $D_{82}$, $D_{83}$, $D_{84}$) de zones opaques théoriques, se fait au moins par application de la formule suivante :

$$D_i = 1 - \frac{Q_i}{Q_{max}}$$

avec i indexant les différentes régions (81, 82, 83, 84) de la résine secondaire (80), $D_i$ la densité théorique associée à la région i, $Q_i$ la dose de rayonnement à laquelle la région i est exposée et $Q_{max} = \max(Q_i)$.

5. Procédé selon la revendication 1 ou la revendication 2 dans lequel l'étape d'obtention de la première valeur de la dérivée comprend les étapes suivantes :

• Fournir un masque test présentant une pluralité de réseaux test présentant chacun une densité distincte de zones opaques test,
• Fournir une résine test de même nature que la résine photosensible (20),
• Insoler une pluralité de régions de la résine test avec un rayonnement au travers du masque test, l'insolation de chaque région se faisant au travers d'un réseau test distinct,
• Déterminer, pour chaque région de la résine test, une épaisseur d'insolation du rayonnement dans ladite région,
• Etablir un modèle reliant l'épaisseur d'insolation de la couche de résine test à la densité de zones opaques test à partir des données d'épaisseur d'insolation obtenues pour chacune des régions.

**6.** Procédé selon l'une quelconque des revendications précédentes dans lequel la première dimension $P_{x,1}$ des premiers pixels (110) selon la première direction (X) et la première dimension $P_{y,1}$ des premiers pixels (110) selon la deuxième direction (Y) sont chacune inférieures à une longueur d'onde principale du rayonnement (50).

**7.** Procédé selon l'une quelconque des revendications précédentes dans lequel les premiers pixels (110) présentent une forme carrée dans le plan horizontal (XY) et dans lequel $P_{x,1}=P_{y,1}=P$.

**8.** Procédé selon l'une quelconque des revendications précédentes dans lequel les premières zones opaques (120) présentent une forme carrée dans le plan horizontal (XY) et dans lequel $L_{x,1}=L_{y,1}=L$.

**9.** Procédé selon les deux revendications précédentes prises en combinaison dans lequel :

$$MEEF(e_1{}^*) = \frac{\partial e_1(D_{100}{}^*)}{\partial D_{100}} \frac{2\sqrt{D_{100}{}^*}}{P}$$

**10.** Procédé selon l'une quelconque des revendications précédentes dans lequel la pluralité de zones opaques comprend au moins des deuxièmes zones opaques (220) se trouvant dans des deuxièmes pixels (210), les deuxièmes pixels (210) formant un deuxième réseau (200) du masque (1), le procédé comprenant en outre les étapes suivantes :

• Etablir une deuxième densité cible $D_{200}^*$ d'une deuxième densité surfacique $D_{200}$ de deuxièmes zones opaques (220) au sein du deuxième réseau (200), la deuxième densité cible $D_{200}^*$ étant configurée pour permettre d'insoler la résine sur une deuxième épaisseur cible $e_2^*$ donnée lorsque la résine est exposée au rayonnement au travers du deuxième réseau (200) du masque (1), la deuxième épaisseur cible $e_2^*$ étant mesurée selon la direction principale du rayonnement, la deuxième épaisseur cible $e_2^*$ étant distincte de la première épaisseur cible $e_1^*$,
• Obtenir une deuxième valeur, pour la deuxième densité cible $D_{200}^*$, de la dérivée par rapport à la deuxième densité surfacique $D_{200}$ de la deuxième épaisseur $e_2$ sur laquelle la résine photosensible est insolée lorsqu'elle est exposée à un rayonnement au travers du deuxième réseau (200) présentant la deuxième densité surfacique

$D_{200}$, notée $\frac{\partial e_2(D_{200}{}^*)}{\partial D_{200}}$ ,

• Déterminer une deuxième dimension $P_{x,2}$ des deuxièmes pixels (210) dans la première direction (X), une deuxième dimension $P_{y,2}$ des deuxièmes pixels (210) dans la deuxième direction (Y), une deuxième dimension $L_{x,2}$ des deuxièmes zones opaques (220) dans la première direction (X), une deuxième dimension $L_{y,2}$ des deuxièmes zones opaques (220) dans la deuxième direction (Y), de façon à ce que la valeur d'une erreur sur la deuxième épaisseur cible $e_2^*$, notée $MEEF(e_2^*)$ soit inférieure à un deuxième seuil donné, $MEEF(e_2^*)$ étant calculé à partir de la formule suivante :

$$MEEF(e_2{}^*) = \frac{\partial e_2(D_{200}{}^*)}{\partial D_{200}} \frac{(a_2 + \beta_2)L_{x,2}}{P_{x,2}P_{y,2}}$$

Avec $\beta_2 = \frac{L_{y,2}}{L_{x,2}}$ et $a_2 = \frac{\delta L_{y,2}}{\delta L_{x,2}}$ , $\delta L_{x,2}$ étant une erreur sur $L_{x,2}$ et $\delta L_{y,2}$ étant une erreur sur $L_{y,2}$,

• Utiliser les dimensions obtenues pour le dimensionnement du deuxième réseau (200) du masque (1).

**11.** Procédé selon la revendication précédente dans lequel le deuxième réseau (200) forme dans le plan horizontal (XY) un contour fermé dans lequel se trouve le premier réseau (100).

**12.** Procédé selon la revendication précédente dans lequel le contour fermé formé par le deuxième réseau (200) est sensiblement circulaire.

**13.** Procédé selon l'une quelconque des deux revendications précédentes dans lequel le deuxième seuil pour l'erreur sur la deuxième épaisseur cible $e_2^*$ est inférieur au premier seuil pour l'erreur sur la première épaisseur cible $e_1^*$.

**14.** Procédé de fabrication d'un masque (1) de lithographie en échelle de gris comprenant les étapes suivantes :

• Dimensionner le masque (1) par mise en œuvre du procédé selon de l'une quelconque des revendications précédentes,
• Fabriquer le masque (1) ainsi dimensionné.

**Patentansprüche**

**1.** Verfahren zur Dimensionierung einer Grauskalalithographiemaske (1), wobei sich die Maske (1) hauptsächlich entlang einer horizontalen Ebene (XY) erstreckt, die durch eine erste Richtung (X) und eine zweite Richtung (Y) definiert ist, wobei die Ebene zu einer Hauptrichtung einer Belichtungsstrahlung eines lichtempfindlichen Harzes (20) durch die Maske (1) senkrecht ist, wobei die Maske (1) eine Vielzahl für die Strahlung undurchlässige Zonen umfasst, wobei sich jede für die Strahlung undurchlässige Zone in einer Zone der Maske (1), die als Pixel bezeichnet wird, befindet, wobei die Vielzahl für die Strahlung undurchlässige Zonen erste undurchlässige Zonen (120) umfasst, die sich in ersten Pixeln (110) befinden, wobei die ersten Pixel (110) ein erstes Raster (100) der Maske (1) bilden, wobei das Verfahren die folgenden Schritte umfasst:

• Erstellen einer ersten Zieldichte $D_{100}*$ mit einer ersten Oberflächendichte D100* erster undurchlässiger Zonen (120) innerhalb des ersten Rasters (100), wobei die erste Zieldichte D100* dazu konfiguriert ist, das Belichten des Harzes (20) auf einer ersten gegebenen Zieldicke e1* zu erlauben, wenn das Harz (20) der Strahlung durch das erste Raster (100) der Maske (1) hindurch ausgesetzt wird, wobei die erste Zieldicke e1* entlang der Hauptstrahlungsrichtung gemessen wird,
• Erhalten eines ersten Wertes für die erste Zieldichte D100* der Ableitung in Bezug auf die erste Oberflächendichte D100 der ersten Dicke e1, auf der das lichtempfindliche Harz (20) belichtet wird, wenn es einer Strahlung durch das erste Raster (100) hindurch ausgesetzt wird, das die erste Oberflächendichte D100 aufweist, wobei der erste Wert bezeichnet wird als $\dfrac{\partial e_1(D_{100}{}^{*})}{\partial D_{100}}$,

• Bestimmen einer ersten Abmessung Px,1 der ersten Pixel (110) in der ersten Richtung (X), einer ersten Abmessung Py,1 der ersten Pixel (110) in der zweiten Richtung (Y) einer ersten Abmessung Lx,1 der ersten undurchlässigen Zonen (120) in der ersten Richtung (X), einer ersten Abmessung Ly,1 der ersten undurchlässigen Zonen (120) in der zweiten Richtung (Y) derart, dass der Wert eines Fehlers auf der ersten Zieldicke e1*, die als MEEF(e1*) bezeichnet wird, kleiner ist als ein erster gegebener Schwellenwert, MEEF(e1*), der ausgehend von der folgenden Formel berechnet wird:

$$MEEF(e_1{}^{*}) = \frac{\partial e_1(D_{100}{}^{*})}{\partial D_{100}} \frac{(a_1 + \beta_1)L_{x,1}}{P_{x,1}P_{y,1}}$$

Wobei $\beta_1 = \frac{L_{y,1}}{L_{x,1}}$ ein Fehler auf Lx,1 ist und wobei $a_1 = \frac{\delta L_{y,1}}{\delta L_{x,1}}$ ein Fehler auf Ly,1 ist,

• Verwenden der erhaltenen Abmessungen für das Dimensionieren des ersten Rasters (100) der Maske (1).

**2.** Verfahren nach dem vorstehenden Anspruch, wobei a1 zwischen 0,8 und 1,2 liegt, bevorzugt gleich 1 ist.

**3.** Verfahren nach einem der vorstehenden Ansprüche, wobei der Schritt des Erhaltens des ersten Wertes der Ableitung die folgenden Schritte umfasst:

• Bereitstellen eines Sekundärharzes (80) mit derselben Beschaffenheit wie das lichtempfindliche Harz (20),
• Belichten einer Vielzahl von Bereichen (81, 82, 83, 84) des Sekundärharzes (80) mit einer Strahlung, wobei jeder Bereich (81, 82, 83, 84) mit einer Dosis (Q81, Q82, Q83, Q84) getrennter Strahlung belichtet wird,
• für jeden Bereich (81, 82, 83, 84) des Sekundärharzes (80) Bestimmen entlang der Hauptrichtung der Strahlung einer Belichtungsdicke der Strahlung in dem Bereich (81, 82, 83, 84),
• Erstellen für jeden Bereich (81, 82, 83, 84) des Sekundärharzes (80) einer theoretischen Dichte (D81, D82, D83, D8) undurchlässiger theoretischer Zonen auf einer theoretischen Maske, die es beim Aussetzen einer Strahlung des Bereichs (81, 82, 83, 84) durch die theoretische Maske hindurch erlaubt hätte, den Bereich mit der Dosis (Q81, Q82, Q83, Q84) der Strahlung, der der Bereich (81, 82, 83, 84) ausgesetzt wird, auszusetzen,

• Erstellen eines Modells, das die Belichtungsdicke der Schicht aus Sekundärharz (80) mit der Dichte undurchlässiger Zonen verbindet, ausgehend von Daten für Belichtungsdicke und theoretische Dichte (D81, D82, D83, D84), die für jeden der Bereiche (81, 82, 83, 84) erhalten werden.

4. Verfahren nach dem vorstehenden Anspruch, wobei der Erstellungsschritt für jeden Bereich (81, 82, 83, 84) des Sekundärharzes (80) der theoretischen Dichte (D81, D82, D83, D84) theoretischer undurchlässiger Zonen mindestens durch Anwendung der folgenden Formel erfolgt:

$$D_i = 1 - \frac{Q_i}{Q_{max}}$$

wobei i die unterschiedlichen Bereiche (81, 82, 83, 84) des Sekundärharzes (80) indexiert, Di die theoretische Dichte, die dem Bereich i zugeordnet ist, Qi die Strahlungsdosis ist, der der der Bereich i ausgesetzt wird, und Qmax = max(Qi).

5. Verfahren nach Anspruch 1 oder Anspruch 2, wobei der Schritt des Erhaltens des ersten Wertes der Ableitung die folgenden Schritte umfasst:

   • Bereitstellen einer Testmaske, die eine Vielzahl von Testrastern aufweist, die jeweils eine unterschiedliche Dichte undurchlässiger Testzonen aufweisen,
   • Bereitstellen eines Testharzes mit derselben Beschaffenheit wie das lichtempfindliche Harz (20),
   • Belichten der Vielzahl von Bereichen des Testharzes mit einer Strahlung durch die Testmaske hindurch, wobei die Belichtung jedes Bereichs durch ein getrenntes Testraster erfolgt,
   • Bestimmen für jeden Bereich des Testharzes einer Belichtungsdicke der Strahlung in dem Bereich,
   • Erstellen eines Modells, das die Belichtungsdicke der Testharzschicht mit der Dichte undurchlässiger Testzonen ausgehend von den für jeden der Bereiche erhaltenen Belichtungsdickedaten verbindet.

6. Verfahren nach einem der vorstehenden Ansprüche, wobei die erste Abmessung Px,1 der ersten Pixel (110) entlang der ersten Richtung (X) und die erste Abmessung Py,1 der ersten Pixel (110) entlang der zweiten Richtung (Y) jeweils kleiner als eine Hauptwellenlänge der Strahlung (50) sind.

7. Verfahren nach einem der vorstehenden Ansprüche, wobei die ersten Pixel (110) eine Quadratform in der horizontalen Ebene (XY) aufweisen, und in der Px,1=Py,1=P.

8. Verfahren nach einem der vorstehenden Ansprüche, wobei die ersten undurchlässigen Zonen (120) eine Quadratform in der horizontalen Ebene (XY) aufweisen, und wobei Lx,1= Ly,1=L.

9. Verfahren nach einem der beiden vorstehenden Ansprüche kombiniert genommen, wobei:

$$MEEF(e_1{}^*) = \frac{\partial e_1(D_{100}{}^*)}{\partial D_{100}} \frac{2\sqrt{D_{100}{}^*}}{P}$$

10. Verfahren nach einem der vorstehenden Ansprüche, wobei die Vielzahl undurchlässiger Zonen mindestens zweite undurchlässige Zonen (220) umfasst, die sich in zweiten Pixeln (210) befinden, wobei die zweiten Pixel (210) ein zweites Raster (200) der Maske (1) bilden, wobei das Verfahren außerdem die folgenden Schritte umfasst:

   • Erstellen einer zweiten Zieldichte D200* mit einer zweiten Oberflächendichte D200 zweiter undurchlässiger Zonen (220) innerhalb des zweiten Rasters (200), wobei die zweite Zieldichte D200* dazu konfiguriert ist, das Belichten des Harzes (20) auf einer zweiten gegebenen Zieldicke e2* zu erlauben, wenn das Harz der Strahlung durch das zweite Raster (200) der Maske (1) hindurch ausgesetzt wird, wobei die zweite Zieldicke e2* entlang der Hauptstrahlungsrichtung gemessen wird, wobei sich die zweite Zieldicke e2* von der ersten Zieldicke e1* unterscheidet,
   • Erhalten eines zweiten Wertes für die zweite Zieldichte D200*, der Ableitung in Bezug auf die zweite Oberflächendichte D200 der zweiten Dicke e2, auf der das lichtempfindliche Harz belichtet wird, wenn es einer Strahlung durch das Raster (200) ausgesetzt wird, das die erste Oberflächendichte D200 aufweist, bezeichnet als $\frac{\partial e_2(D_{200}{}^*)}{\partial D_{200}}$ ,

• Bestimmen einer zweiten Abmessung Px,2 der zweiten Pixel (210) in der ersten Richtung (X), einer zweiten Abmessung Py,2 der zweiten Pixel (210) in der zweiten Richtung (Y), einer zweiten Abmessung Lx,2 der zweiten undurchlässigen Zonen (220) in der ersten Richtung (X), einer zweiten Abmessung Ly,2 der zweiten undurchlässigen Zonen (220) in der zweiten Richtung (Y) derart, dass der Wert eines Fehlers auf der zweiten Zieldicke e2*, der als MEEF(e2*) bezeichnet wird, kleiner ist als ein zweiter gegebener Schwellenwert, MEEF(e2*), der ausgehend von der folgenden Formel berechnet wird:

$$MEEF(e_2{}^*) = \frac{\partial e_2(D_{200}{}^*)}{\partial D_{200}} \frac{(a_2 + \beta_2)L_{x,2}}{P_{x,2}P_{y,2}}$$

wobei $\beta_2 = \frac{L_{y,2}}{L_{x,2}}$ und $a_2 = \frac{\delta L_{y,2}}{\delta L_{x,2}}$ , δLx,2 ein Fehler auf Lx,2 ist und wobei δLy,2 ein Fehler auf Ly,2 ist,

• Verwenden der erhaltenen Abmessungen für das Dimensionieren des zweiten Rasters (200) der Maske (1).

11. Verfahren nach dem vorstehenden Anspruch, wobei das zweite Raster (200) in der horizontalen Ebene (XY) eine geschlossene Kontur bildet, in der sich das erste Raster (100) befindet.

12. Verfahren nach dem vorstehenden Anspruch, wobei die geschlossene, von dem zweiten Raster (200) gebildete Kontur im Wesentlichen kreisförmig ist.

13. Verfahren nach einem der beiden vorstehenden Ansprüche, wobei der zweite Schwellenwert für den Fehler auf der zweiten Zieldicke e2* kleiner ist als der erste Schwellenwert für den Fehler auf der ersten Zieldicke e1*.

14. Herstellungsverfahren einer Grauskalalithographiemaske (1), das die folgenden Schritte umfasst:

• Dimensionieren der Maske (1) durch Umsetzung des Verfahrens nach einem der vorstehenden Ansprüche,
• Herstellen der derart dimensionierten Maske (1).

**Claims**

1. Method for sizing a greyscale lithography mask (1), the mask (1) mainly extending along a horizontal plane (XY) defined by a first direction (X) and a second direction (Y), the plane being perpendicular to a main direction of a light-exposing radiation of a photosensitive resin (20) through the mask (1), the mask (1) comprising a plurality of opaque zones to the radiation, each opaque zone being located in a zone of the mask (1) called pixel, the plurality of opaque zones comprising first opaque zones (120) being located in first pixels (110), the first pixels (110) forming a first grating (100) of the mask (1), the method comprising the following steps:

• Establishing a first target density $D_{100}{}^*$ of a first surface density $D_{100}$ of first opaque zones (120) within the first grating (100), the first target density $D_{100}{}^*$ being configured to enable the resin (20) to be exposed to light over a first given target thickness $e_1{}^*$ when the resin (20) is exposed to radiation through the first mask (1) grating (100), the first target thickness $e_1{}^*$ being measured in the main direction of the radiation,
• Obtaining a first value, for the first target density $D_{100}{}^*$, of the derivative with respect to the first surface density $D_{100}$ of the first thickness $e_1$ over which the photosensitive resin (20) is exposed to light, when it is exposed to a radiation through the first grating (100) having the first surface density $D_{100}$, said first value being referenced $\frac{\partial e_1(D_{100}{}^*)}{\partial D_{100}}$ ,

• Determining a first dimension $P_{x,1}$ of the first pixels (110) in the first direction (X), a first dimension $P_{y,1}$ of the first pixels (110) in the second direction (Y), a first dimension $L_{x,1}$ of the first opaque zones (120) in the first direction (X), a first dimension $L_{y,1}$ of the first opaque zones (120) in the second direction (Y), such that the value of an error over the first target thickness $e_1{}^*$, referenced MEEF($e_1{}^*$), is less than a first given threshold, MEEF($e_1{}^*$) being calculated from the following formula:

$$MEEF(e_1{}^*) = \frac{\partial e_1(D_{100}{}^*)}{\partial D_{100}} \frac{(a_1 + \beta_1)L_{x,1}}{P_{x,1}P_{y,1}}$$

With $\beta_1 = \frac{L_{y,1}}{L_{x,1}}$ and $a_1 = \frac{\delta L_{y,1}}{\delta L_{x,1}}$, $\delta L_{x,1}$ being an error over $L_{x,1}$ and $\delta L_{y,1}$ being an error over $L_{y,1}$,

- Using the dimensions obtained for the sizing of the first mask (1) grating (100).

2. Method according to the preceding claim, wherein $a_1$ is between 0.8 and 1.2, preferably a is equal to 1.

3. Method according to any one of the preceding claims, wherein the step of obtaining the first value of the derivative comprises the following steps:

- Providing a secondary resin (80) of the same nature as the photosensitive resin (20),
- Exposing a plurality of regions (81, 82, 83, 84) of the secondary resin (80) to light with a radiation, each region (81, 82, 83, 84) being exposed to light with a distinct dose ($Q_{81}$, $Q_{82}$, $Q_{83}$, $Q_{84}$) of radiation,
- For each region (81, 82, 83, 84) of the secondary resin (80), determining in the main direction of the radiation, a light-exposing thickness of the radiation in said region (81, 82, 83, 84),
- Establishing, for each region (81, 82, 83, 84) of the secondary resin (80), a theoretical density ($D_{81}$, $D_{82}$, $D_{83}$, $D_{84}$) of theoretical opaque zones on a theoretical mask, which, during exposure to a radiation of said region (81, 82, 83, 84) through the theoretical mask, would have made it possible to expose said region to the dose ($Q_{81}$, $Q_{82}$, $Q_{83}$, $Q_{84}$) of radiation, to which said region (81, 82, 83, 84) is exposed,
- Establishing a model connecting the light-exposing thickness of the secondary resin layer (80) to the opaque zone density from light-exposing thickness and theoretical density data ($D_{81}$, $D_{82}$, $D_{83}$, $D_{84}$) obtained for each of the regions (81, 82, 83, 84).

4. Method according to the preceding claim, wherein the step of establishing, for each region (81, 82, 83, 84) of the secondary resin (80), of the theoretical density ($D_{81}$, $D_{82}$, $D_{83}$, $D_{84}$) of theoretical opaque zones, is done at least by application of the following formula:

$$D_i = 1 - \frac{Q_i}{Q_{max}}$$

with i indexing the different regions (81, 82, 83, 84) of the secondary resin (80), $D_i$ the theoretical density associated with the region i, $Q_i$ the dose of radiation to which the region i is exposed and $Q_{max} = max(Q_i)$.

5. Method according to claim 1 or claim 2, wherein the step of obtaining the first value of the derivative comprises the following steps:

- Providing a test mask having a plurality of test gratings, each having a distinct density of test opaque zones,
- Providing a test resin of the same nature as the photosensitive resin (20),
- Exposing a plurality of regions of the test resin to light with a radiation through the test mask, the exposing to light of each region being done through a distinct test grating,
- Determining, for each region of the test resin, a light-exposing thickness of the radiation in said region,
- Establishing a model connecting the light-exposing thickness of the test resin layer to the density of test opaque zones from light-exposing thickness data obtained for each of the regions.

6. Method according to any one of the preceding claims, wherein the first dimension $P_{x,1}$ of the first pixels (110) in the first direction (X) and the first dimension $P_{y,1}$ of the first pixels (110) in the second direction (Y) are each less than a main wavelength of the radiation (50).

7. Method according to any one of the preceding claims, wherein the first pixels (110) have a square shape in the horizontal plane (XY) and wherein $P_{x,1} = P_{y,1} = P$.

8. Method according to any one of the preceding claims, wherein the first opaque zones (120) have a square shape in the horizontal plane (XY) and wherein $L_{x,1} = L_{y,1} = L$.

9. Method according to the two preceding claims combined, wherein:

$$MEEF(e_1{}^*) = \frac{\partial e_1(D_{100}{}^*)}{\partial D_{100}} \frac{2\sqrt{D_{100}{}^*}}{P}$$

10. Method according to any one of the preceding claims, wherein the plurality of opaque zones comprises at least second opaque zones (220) being located in second pixels (210), the second pixels (210) forming a second mask (1) grating (200), the method further comprising the following steps:

   • Establishing a second target density $D_{200}$* of a second surface density $D_{200}$ of second opaque zones (220) within the second grating (200), the second target density $D_{200}$* being configured to enable the resin to be exposed to light over a second given target thickness $e_2$* when the resin is exposed to the radiation through the second mask (1) grating (200), the second target thickness $e_2$* being measured in the main direction of the radiation, the second target thickness $e_2$* being distinct from the first target thickness $e_1$*,
   • Obtaining a second value, for the second target density $D_{200}$*, of the derivative with respect to the second surface density $D_{200}$ of the second thickness $e_2$ over which the photosensitive resin is exposed to light when it is exposed to a radiation through the second grating (200) having the second surface density $D_{200}$, referenced

   $$\frac{\partial e_2(D_{200}{}^*)}{\partial D_{200}},$$

   • Determining a second dimension $P_{x,2}$ of the second pixels (210) in the first direction (X), a second dimension $P_{y,2}$ of the second pixels (210) in the second direction (Y), a second dimension $L_{x,2}$ of the second opaque zones (220) in the first direction (X), a second dimension $L_{y,2}$ of the second opaque zones (220) in the second direction (Y), such that the value of an error over the second target thickness $e_2$*, referenced MEEF($e_2$*) is less than a second given threshold, MEEF($e_2$*) being calculated from the following formula:

   $$MEEF(e_2{}^*) = \frac{\partial e_2(D_{200}{}^*)}{\partial D_{200}} \frac{(a_2+\beta_2)L_{x,2}}{P_{x,2}P_{y,2}}$$

   With $\beta_2 = \frac{L_{y,2}}{L_{x,2}}$ and $a_2 = \frac{\delta L_{y,2}}{\delta L_{x,2}}$, $\delta L_{x,2}$ being an error over $L_{x,2}$ and $\delta L_{y,2}$ being an error over $L_{y,2}$,

   • Using the dimensions obtained for the sizing of the second mask (1) grating (200).

11. Method according to the preceding claim, wherein the second grating (200) forms, in the horizontal plane (XY), a closed contour, wherein the first grating (100) is located.

12. Method according to the preceding claim, wherein the closed contour formed by the second grating (200) is substantially circular.

13. Method according to any one of the two preceding claims, wherein the second threshold for the error over the second target thickness $e_2$* is less than the first threshold for the error over the first target thickness $e_1$*.

14. Method for manufacturing a greyscale lithography mask (1) comprising the following steps:

   • Sizing the mask (1) by implementation of the method according to any one of the preceding claims,
   • Manufacturing the mask (1) thus sized.

FIG. 1A

FIG. 1B

FIG. 1C

FIG. 1D

FIG. 2A

FIG. 2B

## Étape 1

FIG. 3

FIG. 4

FIG. 5

FIG. 6

FIG. 7A

FIG. 7B

FIG. 8A

FIG. 8B

FIG. 8C

FIG. 8D

FIG. 8E

FIG. 8F

Définition de la densité surfacique $D_{100}*$
au sein du premier réseau pour obtenir
l'épaisseur $e_{UV}*$ souhaitée
Choix d'un premier couple ($P_1^{i=1}$, $L_1^{i=1}$) en
fonction de $D_{100}*$
Initialisation : i=1

Calcul de $\Delta h$ pour le couple ($P_1^i$, $L_1^i$)

i=i+1

Choix d'un nouveau couple ($P_1^{i+1}$, $L_1^{i+1}$)

$\Delta h > \Delta h_{seuil}$ ?

OUI

NON

Utilisation du dernier couple ($P_1^i$, $L_1^i$)
calculé dans le dimensionnement du
premier réseau

FIG. 9A

Détermination du nombre N de réseaux
à dimensionner au sein du masque

Initialisation : j=1

Définition de la densité surfacique $D_j*$
au sein du réseau n°j pour obtenir
l'épaisseur $e_{UV,j}*$ souhaitée
Choix d'un premier couple $(P_j^{i=1}, L_j^{i=1})$ en
fonction de $D_j*$

Calcul de Δh pour le couple $(P_j^{i=1}, L_j^{i=1})$

i=i+1

Choix d'un nouveau couple $(P_j^{i+1}, L_j^{i+1})$

j=j+1

Δh> $Δh_{seuil}$ ?

OUI

NON

Utilisation du dernier couple $(P_j^{i=1}, L_j^{i=1})$
calculé dans le dimensionnement du
réseau n°j

j=N ?

OUI

Utilisation des derniers couples $(P_j^i, L_j^i)$
calculés dans le dimensionnement des N
réseaux

FIG. 9B

## RÉFÉRENCES CITÉES DANS LA DESCRIPTION

**Documents brevets cités dans la description**

- US 2005233228 A1
- FR 2968780 A1
- US 2021255543 A1
- US 2005118515 A1